# EUROPEAN PATENT APPLICATION

(11) **EP 3 589 092 A1**
(43) Date of publication of application: **01.01.2020**
(21) Application number: 18180807.2
(22) Date of filing: 29.06.2018
(51) Int. Cl.: H05K 3/46, H05K 1/02, H01L 23/498, H01L 23/13, H01L 23/538

(54) **FOLDABLE LAYERED CONNECTION, AND METHOD FOR MANUFACTURING A FOLDABLE LAYERED CONNECTION**

(71) Applicant: INL - International Iberian Nanotechnology Laboratory, 4715-330 Braga (PT); Inesc Mn, 1000-029 Lisboa (PT)
(72) Inventor: Maria Alves Dias, Rosana, 4705-424 Celeirós, Braga (PT); Carlos Azevedo Gaspar, Joâo, 4715-330 Braga (PT); Ferreira, Ricardo, 4715-330 Braga (PT); Jorge Peixeiro de Freitas, Paulo, 2730-287 Barcarena, Oeiras (PT); Isabel Pinheiro Cardoso de Freitas, Susana, 2730-287 Barcarena, Oeiras (PT); Filipe Rodrigues Franco, Fernando, 2460-743 Vestiaria-Alcobaca (PT)
(74) Representative: AWA Sweden AB

(57) **Abstract**

The present inventive concept relates to a foldable layered connection (100, 500) comprising: a substrate (102, 502) having a first major surface (104, 504) and an opposing second major surface (106, 506); a node of connector material (120, 520) arranged to contact the substrate (102, 502) via the first major surface (104, 504); a released extension (126, 526) comprising a core of connector material arranged to be in communicative contact with the node of connector material (120, 520), and flexible material arranged to at least partially enclose the core; wherein the released extension (126, 526) is configured to be hingedly connected to the node (120, 520) and to fold towards the second major surface (106, 506). Methods related to the foldable layered connection are also disclosed.

## Description

### Technical field

The inventive concept described herein generally relates to the field of semiconductor device fabrication.

### Background

Chip or die integration has been used to decrease space requirements of components, to achieve high circuit density, high performance, and low cost. When devices or circuits cannot be integrated on the same die, techniques such as system-in-package (SiP) or 3D IC (three-dimensional integrated circuit) stacking may be used. In these advanced packaging techniques, the connections between the dies are accomplished using methods such as wire bonding, through-silicon-vias (TSVs) or I/O BGA (ball grid array) balls (e.g. redistribution layer bumps).

Such bumps, or microbumps, used in flip-chip technology have good electrical properties but some applications are incompatible with flip-chip technology, such as image sensors, MEMS (Microelectromechanical systems) accelerometers, oscillators and pressure sensors.

TSVs have a reduced resistive-capacitive (RC) delay compared to wire bonding given the shorter connection length, thus allowing for higher bandwidths. However, the fabrication cost of TSVs has limited its commercial application.

Further, there has been a significant amount of research on connecting rigid integrated circuits to flexible interconnects. Several applications require placement of a device in locations that are hard to reach or benefit from flexible connections due to mechanical damage susceptibility. Examples include biomedical devices such as flexible neural interfaces, read-write magnetic heads, flexible displays, and lab-on-a-chip devices. Some adopted solutions package individually diced chips in flexible substrates a *posteriori.*

There is a need for improved flexible connections with respect to at least manufacturing, packaging, and ease of use.

### Summary of the invention

It is an object of the present inventive concept to mitigate, alleviate or eliminate one or more of the above-identified deficiencies in the art and disadvantages singly or in combination.

According to a first aspect of the inventive concept, these and other objects are achieved in full, or at least in part, by a method for manufacturing a foldable layered connection on a substrate, the method comprising: providing a substrate having a first major surface and an opposing second major surface; providing a first layer of sacrificial material over the first major surface; providing a first layer of flexible material over the first layer of sacrificial material, thereby at least partially encapsulating the first layer of sacrificial material; providing an opening in the first layer of flexible material, thereby exposing at least a portion of the substrate; providing a first layer of connector material over the first layer of flexible material and the substrate, the first layer of connector material being in contact with the substrate, thereby forming a first contact of connector material and a node of connector material; providing a second layer of flexible material over the first layer of connector material, the second layer of flexible material being in contact with the first layer of flexible material, thereby at least partly encapsulating the first layer of connector material; exposing at least a portion of the second layer of connector material, thereby forming a second contact of connector material; and removing the first layer of sacrificial material and a portion of the substrate, thereby forming a released extension which is foldable towards the second major surface of the substrate, the released extension comprising at least part of the first and second layer of flexible material, and the at least partly encapsulated first layer of connector material.

To facilitate the overall description a coordinate system will be used, where the x- and y-axis extend in an extension plane of the first major surface of the substrate, whereas the z-axis extends perpendicular to the extension plane of the substrate.

It will be understood that when a component, such as a layer, a film, a region, or a plate, is referred to as being "on" another component, the component may be directly on the other component or intervening components may be present thereon.

Further, it will be understood that some parts of the processes in the present disclosure may be omitted for the sake of brevity. In particular, some steps of masking, patterning, or etching may be omitted since it is believed that the person skilled in the art understands from the present disclosure as a whole how these steps are to be carried out within the present inventive concept. Further, some steps of patterning may be achieved through e.g. lithography, reactive ion etching, and/or liftoff.

The term 'providing' may in the context of the present disclosure comprise depositing, forming, and/or patterning. For example, in the case of 'providing a first layer of material', it is to be understood that the first layer of material may be deposited, formed, and/or patterned. In particular, a material may be formed and/or patterned during the process of depositing the material. The term 'providing' may also comprise material already being present when performing the method according to the inventive concept.

The term 'depositing' in the context of depositing layers of material should be interpreted broadly as to include any technique of forming a layer of material. In particular, the term 'deposit' may encompass spin coating, chemical vapor deposition, physical vapor deposition, sputtering, and similar techniques. The term 'depositing' in the context of depositing material may comprise forming or patterning of the material via various techniques including photolithography, etching, lift-off etc.

The term 'patterning' in the context of depositing material may comprise forming or patterning of the material via various techniques including photolithography, etching, lift-off, masking etc.

When materials such as 'flexible material', 'connector material', or sacrificial material' are being referred to, it is not necessarily one and the same type of material. The person skilled in the art realizes that it may be possible to use different types of e.g. flexible material in the foldable layered connection. In other words, different layers may comprise different types of e.g. flexible material, sacrificial material or connector material.

In the context of the present disclosure, the term 'meander shaped' should be understood to comprise bends, turns, windings, curves, annular shapes, right angles, acute angles, and obtuse angles. In particular, a meander shape may refer to a spiral shape.

In the context of the present disclosure, the term 'hingedly connected' does not imply a structure resembling a hinge, but rather that the connection may achieve a rotation around a virtual axis. The term 'hingedly connected' may be exchanged for 'flexibly connected' or 'movably connected'.

In general, the terminology used, e.g. referring to a 'first', 'second', or 'third' layer, should not be interpreted as limiting the scope of the inventive concept, but merely as means for providing clarity in the following disclosure.

The first contact of connector material may be in contact with the substrate, thus the foldable layered connection may provide routing and/or contact between the substrate and a device in communication with the second contact of connector material.

The node of connector material may be, or comprise, the first contact of connector material.

The released extension may be configured to be folded such that the second contact of connector material is located on or at the second major surface of the substrate. Hereby, routing between the first major surface and the second major surface may be provided.

The node of connector material may be arranged at a first distance from a free edge of the substrate, wherein the released extension is configured to fold over the free edge towards the second major surface of the substrate.

The at last partly encapsulated second layer of connector material may be seen as a core. The core may be given a longitudinal extension and allow transfer of a signal from and/or to the substrate.

The first layer of connector material may be in contact with the first major surface of the substrate. Hereby, the first layer of connector material may be able to propagate a signal from and/or to the substrate.

The step of providing the opening in the first layer of sacrificial material may be performed by etching. As will be understood from the present disclosure, the flexible material may preferably be a flexible material being resistant to the etchant used to remove the sacrificial material. Further, the connector material may preferably be a connector material being resistant to the etchant used to remove the sacrificial material.

The method may further comprise forming at least one access channel arranged to access the first layer of sacrificial material, wherein the step of providing the opening in the first layer of sacrificial material is performed by etching via the at least one access channel. The at least one access channel may be formed by removing a portion of the first and second layer of flexible material and/or by removing a portion of the substrate. Hereby, etching may be performed using etchants which must not necessarily be able to permeate through the flexible material. Further, etching speed and/or precision may be improved, even when utilizing etchants which are able to permeate or penetrate through the flexible material.

The etchant may be HF. It is to be understood that other etchants may be used, such as acetone or any organic or inorganic solvent which may selectively etch the sacrificial material with respect to the flexible material and the connector material. The HF may be in the form of vapor and/or liquid.

The sacrificial material may be SiO₂. It is to be understood that other sacrificial materials may be used, such as photoresists, PMMA, or other materials for which there exist a solvent or etchant which selectively attacks the material with respect to the flexible material and the connector material.

The flexible material may be polyimide. It is to be understood that other flexible materials may be used, such other materials are preferably flexible materials which can be deposited and patterned and which are resistant to the solvent or etchants utilized to remove the sacrificial material.

The combination of HF, SiO₂, and polyimide as disclosed above may provide for that SiO₂ can be etched through the layers of polyimide, since polyimide is permeable to HF. As is readily understood by the person skilled in the art, there may exist other possible materials and material combinations within the scope of the inventive concept which may provide the same or similar advantages. One combination of etchant, sacrificial material, flexible material and connecting material is HF, photoresist, PMMA and metal respectively.

The released extension may be straight or meander shaped. Hereby, a length of the released extension may be increased without occupying a significant surface area in a single particular direction.

The released extension may be divided into several separate branches, or sub-extensions, each functioning as a single released extension and each having a core of connector material. Each sub-extension may have a different length and/or width. Hereby, several foldable layered sub-connections may be achieved.

The first and second layer of flexible material may have the same thickness. Hereby, the connector material may be kept at a neutral axis of the released extension, which may reduce stress on the connector material as the released extension is flexed, i.e. when the foldable layered connection is folded. It is to be understood that the term 'the same thickness' should be interpreted broadly, and encompasses e.g. 'substantially the same thickness'.

A patterning of the first layer of sacrificial material may determine the shape or form of the released extension. In other words, a pattern, shape or form of the first layer of sacrificial material may indirectly determine a pattern, shape or form of the released extension.

The substrate may be a silicon wafer or a printed circuit board or a semiconductor substrate.

The connector material may be an electrically conductive material. However, it may also be possible to manufacture a foldable layered connection according to the inventive concept comprising connector material pertaining to other communication techniques, such as light or heat. Consequently, the connector material may be configured to guide light signals, or to conduct heat. A material which conduct light signals should preferably have low optical loss, such as PMMA, EpoCore, or other transparent, flexible and/or ductile polymers. A flexible material in this regard could for example be EpoClad. It is also envisioned that the connecting material in a light signaling application may be flexible in itself, and comprise a thin reflective metal coating. The connector material may by way of example be AlSiCu or TiW.

The released extension may be brought into contact with the second major surface, thereby providing routing between the first major surface and the second major surface.

A thickness of the released extension along a z-axis may be controlled by depositing a specific thickness of the respective layers forming the released extension, e.g. the first and second layer of flexible material and the second layer of connector material. Preferably, the thickness of the released extension is chosen such that the released extension is allowed to substantially conform to a shape of the substrate when the released extension is folded towards the second major surface of the substrate. Accordingly, the released extension is flexible.

As already discussed, a length of the released extension may be controlled via the first layer of sacrificial material. In particular, the released extension may be at least as long as the first layer of sacrificial material along the x- and/or y-axis. The length of the released extension, and/or a thickness of the substrate, and/or the first distance from the free edge of the substrate may be chosen in order to control a position of the second contact of connector material on the second major surface of the substrate. In particular, different applications may require different positions of the second contact of connector material on the second major surface of the substrate.

The substrate may be a silicon wafer or a printed circuit board or a semiconductor substrate.

According to a second aspect of the inventive concept, these and other objects are achieved in full, or at least in part, by a foldable layered connection comprising: a substrate having a first major surface and an opposing second major surface; a node of connector material arranged to contact the substrate via the first major surface; a released extension comprising a core of connector material arranged to be in communicative contact with the node, and flexible material arranged to at least partially enclose the core; wherein the released extension is configured to be hingedly connected to the node and to fold towards the second major surface.

The released extension may be further configured to fold towards the second major surface such that the released extension is brought into contact with the second major surface, thereby providing routing between the first major surface and the second major surface.

According to a third aspect of the inventive concept, these and other objects are achieved in full, or at least in part, by a use of a foldable layered connection according to the second aspect on a silicon wafer or a printed circuit board.

In general, the present inventive concept provides an efficient fabrication process of a foldable layered connection on a substrate, wherein the packaging of the device may be integrated with the device fabrication itself. The foldable layered connection may provide a front-side to backside connection on a substrate.

A feature described in relation to one aspect may also be incorporated in other aspects, and the advantage of the feature is applicable to all aspects in which it is incorporated.

Other objectives, features and advantages of the present inventive concept will appear from the following detailed disclosure, from the attached claims as well as from the drawings.

Generally, all terms used in the claims are to be interpreted according to their ordinary meaning in the technical field, unless explicitly defined otherwise herein. Further, the use of terms "first", "second", and "third", and the like, herein do not denote any order, quantity, or importance, but rather are used to distinguish one element from another. All references to "a/an/the [element, device, component, means, step, etc]" are to be interpreted openly as referring to at least one instance of said element, device, component, means, step, etc., unless explicitly stated otherwise. The steps of any method disclosed herein do not have to be performed in the exact order disclosed, unless explicitly stated.

### Brief description of the drawings

The above, as well as additional objects, features and advantages of the present inventive concept, will be better understood through the following illustrative and non-limiting detailed description of different embodiments of the present inventive concept, with reference to the appended drawings, wherein:
FIGS. 1a - 1k schematically illustrate a method for manufacturing a foldable layered connection;
FIG. 2 schematically illustrates an example of a foldable layered connection in a perspective view;
FIG. 3 schematically illustrates an example of a foldable layered connection in a perspective view;
FIG. 4 schematically illustrates an example of a foldable layered connection in a perspective view;
FIGS. 5a - 5h schematically illustrate a method for manufacturing a foldable layered connection according to one aspect of the inventive concept.

### Detailed description

It may be repeated that some parts of the processes in the present disclosure may be omitted for the sake of brevity. In particular, some steps of masking, patterning, or etching may be omitted since it is believed that the person skilled in the art understands from the present disclosure as a whole how these steps are to be carried out within the present inventive concept. Some possible techniques which may be incorporated into the method described below include chemical vapor deposition (CVD), plasma etching, ashing, reactive ion etching (RIE), dry etching, inductively coupled plasma etching, lithography, and sputtering. Further, the illustrations are schematic and not to scale. In particular, the thickness of some layers have been exaggerated in order to more clearly illustrate the composition of the foldable layered connection.

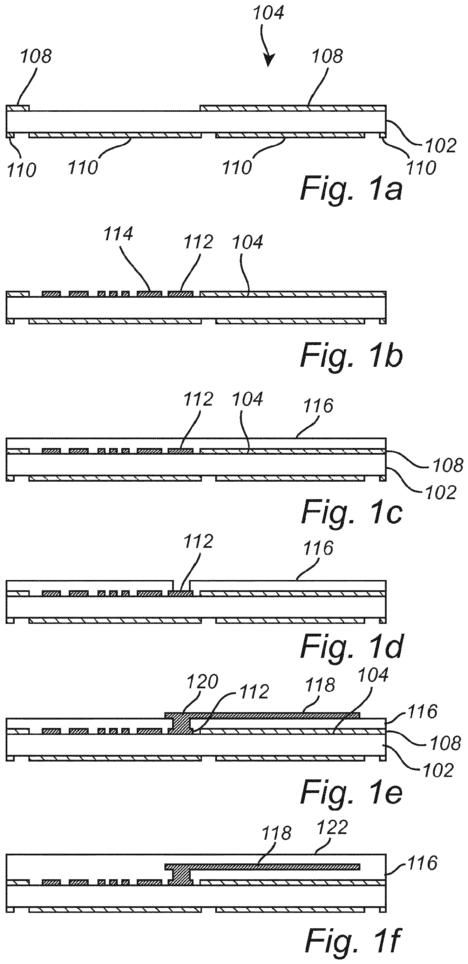

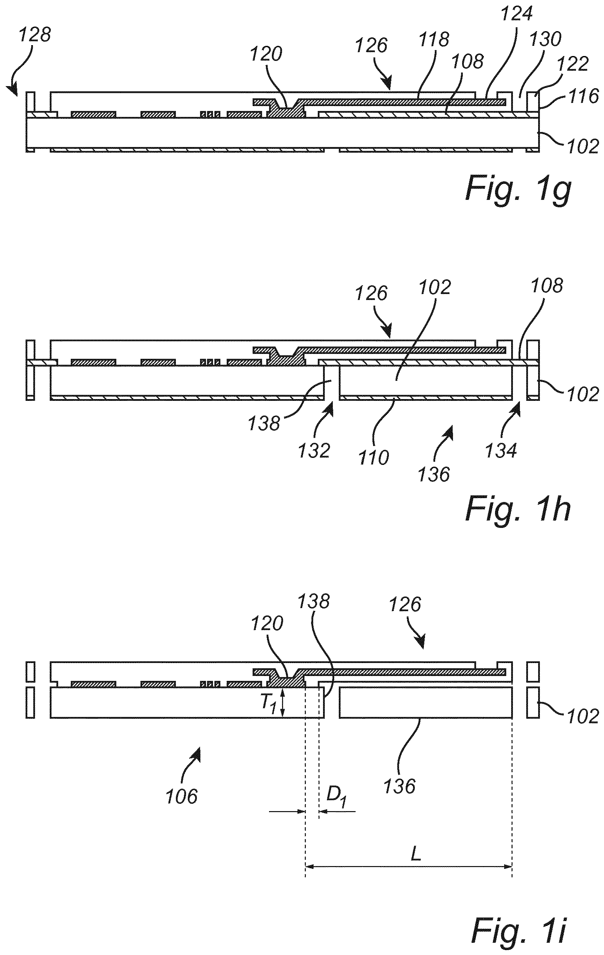

Further, it may be noted that the features of the foldable layered connection in FIGS. 1a - 1f are illustrated with slightly less detail than in FIGS. 1g - 1k. However, FIGS. 1a - 1f should not be seen as a separate embodiment with respect to FIGS. 1g - 1k. Further, the illustrated FIGS. 1a - 1k may be seen as a mere schematic visualization of the inventive concept, and attention to e.g. specific shape of the different features need not necessarily be given.

FIGS. 1a - 1k illustrates a method for manufacturing a foldable layered connection 100. It should be noted that although figures are denominated alphabetically, at least some steps disclosed in conjunction with the figures need not necessarily be performed in the specific order presented.

Referring first to FIG. 1a, a substrate 102 having a first major surface 104 and an opposing second major surface 106 is provided. A first layer of sacrificial material 108 has been deposited over the first major surface 104. A second layer of sacrificial material 110 may also be deposited on the second major surface 106. As can be seen, the first and second layer of sacrificial material 108, 110 have been patterned and/or formed. In particular, the first layer of sacrificial material 108 does not cover the whole first major surface 104, i.e. a part of the first major surface 104 has been exposed. Similarly, at least a part of the second major surface 106 may be exposed.

Referring now to FIG. 1b, a first layer of connector material has been deposited onto the first major surface 104. The first layer of connector material is formed into a first contact of connector material 112. The first layer of connector material may be formed into the first contact of connector material 112 by removing part of the first layer of connector material, e.g. by a lithographic process. In other words, the first contact of connector material 112 is part of the first layer of connector material. It is envisioned that the first layer of connector material may be formed into other arrangements or structures 114 as illustrated in the figure. The other arrangements or structures 114 may provide additional functionality to the foldable layered connection. It may be noted that also the other arrangements or structures 114 are part of the first layer of connector material.

Referring now to FIG. 1c, a first layer of flexible material 116 has been deposited onto the first layer of sacrificial material 108. The first layer of flexible material 116 may also, as illustrated, be deposited onto the first major surface 104, and the first layer of connector material, e.g. the first contact of connector material 112. The first layer of flexible material 116 at least partially encapsulates the first layer of sacrificial material 108. In particular, the first layer of sacrificial material 108 may be at least partially encapsulated by the first layer of flexible material 116 and the substrate 102. Further, the first contact of connector material 112 may be at least partially encapsulated by the first layer of flexible material 116. In particular, the first layer of sacrificial material 108 may be encapsulated by the first layer of flexible material 116, and/or the first contact of connector material 112 may be encapsulated by the first layer of flexible material 116.

Referring now to FIG. 1d, a portion of the first layer of flexible material 116 is removed. The removal of the portion of the first layer of flexible material 116 may be performed by etching. The first contact of connector material 112 may thus be exposed. It is also envisioned that the first layer of connector material, and thus the first contact of connector material 112, may be deposited and formed e.g. after the step of depositing the first layer of flexible material 116, instead of in the step disclosed in conjunction with FIG. 1b.

Referring now to FIG. 1e, a second layer of connector material 118 is deposited onto the first layer of flexible material 116. The second layer of connector material 118 is in contact with the first layer of connector material, and in particular in contact with the first contact 112, thereby forming a node of connector material 120. The node of connector material 120 may be arranged to contact the substrate 102 via the first major surface 104. The second layer of connector material 114 may be patterned to extend substantially in a first direction along the first major surface 104. In particular, the second layer of connector material 114 may be patterned such that at least part of the second layer of connector material 114 is arranged over the first layer of sacrificial material 108. Hereby, when the first layer of sacrificial material 108 is removed, at least part of the second layer of connector material 118, forming part of a released extension, may be released.

Referring now to FIG. 1f, a second layer of flexible material 122 has been deposited onto the second layer of connector material 118. The second layer of flexible material 122 is in contact with the first layer of flexible material 116, thereby at least partly encapsulating the second layer of connector material 118.

Referring now to FIG. 1g, at least a portion of the second layer of connector material 118 has been exposed, thereby forming a second contact of connector material 124. The second contact of connector material 124 may be in contact with the first contact of connector material via the second layer of connector material 118. The second contact of connector material 124 may enable input to and/or output of a signal from the foldable layered connection. Further, a portion of the first and second layer of flexible material 116, 122 has been removed in order to at least partially expose an extension 126 comprising at least part of the first and second layer of flexible material 116, 122, and the at least partly encapsulated second layer of connector material 118. In other words, the extension 126 may comprise a core of connector material, and flexible material arranged to at least partially enclose the core. Thus, the at least partly encapsulated second layer of connector material 118 may be seen as a core. By removing a portion of the first and second layer of flexible material 116, 122, the extension 126 may be laid bare from neighboring foldable layered connections 128 manufactured on the same substrate 102. The removal of a portion of the first and second layer of flexible material 116, 122 may also provide for that the extension 126 will be released, as described in conjunction with FIG. 1i, when the first layer of sacrificial material 108 is removed. It should be noted that the illustrated example only shows a two-dimensional representation of the inventive concept, i.e. in a xz-plane. In particular, a portion of flexible material may be removed also in a plane not shown in the illustrated example, e.g. in a xy-plane. Further, the removal of a portion of the first and second layer of flexible material 116, 122 may also form an access channel 130 arranged to access sacrificial material, e.g. the first layer of sacrificial material 108.

Referring now to FIG. 1h, a first and a second channel 132, 134 has been formed. The first and second channels may 132, 134 may be formed by e.g. etching. The first and second channels 132, 134 may extend through the substrate 102 and reach the first layer of sacrificial material 108. The second layer of sacrificial material 110 may facilitate the forming of the channels 132, 134. Further, the first and second channel 132, 134 may define an isolated portion 136 comprising part of the substrate 102 and part of the second layer of sacrificial material 110. The isolated portion 136 may be connected to the extension 126 via the first layer of sacrificial material 108. The isolated portion 136 may be removed by removing the second layer of sacrificial material 110. When removing a portion of the substrate 102, a free edge 138 of the substrate 102 will be created.

It is to be understood that the access channel referred to in conjunction with FIG. 1g, and the channels referred to in conjunction with FIG. 1h, may possess similar properties and may achieve the same advantages. Accordingly, in one example, the first and second channel 132, 134 may be seen as access channels arranged to access the first layer of sacrificial material 108. A step of removing the first layer of sacrificial material may be performed by etching via at least one of the first and second channel 132, 134.

It is also envisioned that a portion of the substrate 102 may be removed by e.g. etching. In this case, the second layer of sacrificial material 110 may have a large opening allowing an area corresponding to the isolated portion 136 to be etched.

Referring now to FIG. 1i, the first layer of sacrificial material 108 has been removed, thus freeing and removing the isolated portion 136 from the rest of the foldable layered connection. Further, the extension 126 is released, and allowed to fold towards the second major surface 106. Also the second layer of sacrificial material 110 has been removed. The location of the node of connector material 120 with respect to the free edge 138 may determine how far the released extension 126 can reach on the second major surface 106, i.e. the first distance D₁ from the node of connector material 120 to the free edge 138 may determine how far the released extension 126 can reach on the second major surface 106. In this context, also a thickness T₁ of the substrate 102 may determine how far the released extension 126 can reach on the second major surface 106. Further, also in this context, a length L of the released extension 126 may determine how far the released extension 126 can reach on the second major surface 106. As readily understood by the person skilled in the art, any combination of the first distance D₁, thickness T₁, and length L may determine how far the released extension 126 can reach on the second major surface 106. It may also be noted that the released extension 126 may protrude a length L - D₁ over a free edge 138 of the substrate.

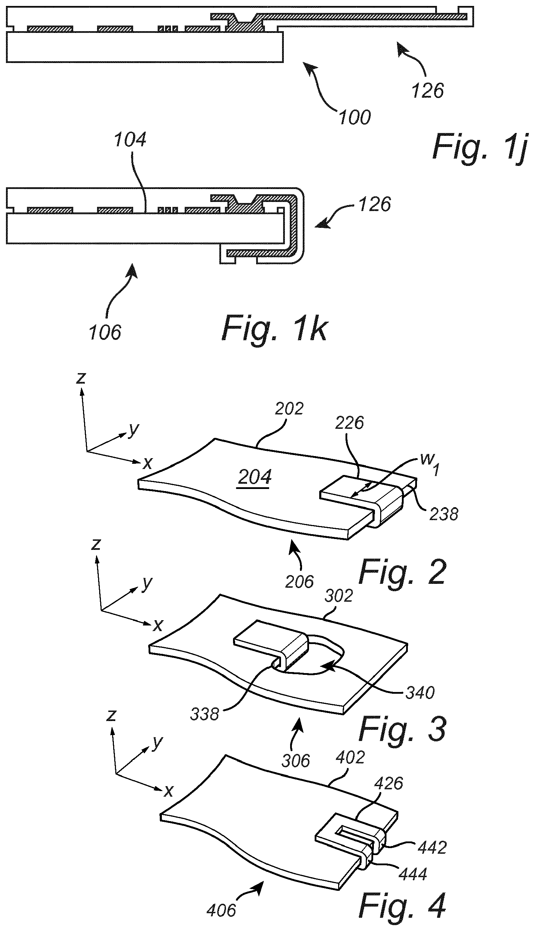

Referring now to FIG. 1j, the released extension 126 of the foldable layered connection 100 is illustrated.

Referring now to FIG. 1k, the released extension 126 has folded towards the second major surface 106, and the released extension 126 has contacted the second major surface 106, thereby providing routing between the first major surface 104 and the second major surface 106. It may be noted that in the illustrated example, the second contact of connector material is facing away from the second major surface 106. However, it is also envisioned that the second contact of connector material may be facing towards the second major surface 106 in a folded state, such that a connection between the first major surface 104 and the second major surface 106 is achieved.

Referring now to FIG. 2, a foldable layered connection is schematically illustrated in a perspective view. The illustration has been purposely simplified in order to more clearly convey the features discussed below. A released extension 226 is shown on a substrate 202. The released extension 226 is arranged on the first major surface 204 of the substrate 202, and the released extension 226 is folded, over the free edge 238, towards the second major surface 206 of the substrate 202. In this perspective view, it can also be seen that the released extension may have a width W₁ along the y-axis. However, the released extension 226 need not necessarily be uniform in shape as shown, instead the width W₁ may vary over a length of the released extension 226.

Further, it should be noted that the illustration shows a cutout of the substrate 202, and that the substrate 202 may have a different shape, and/or extension in the xy-plane. It should also be noted that the released extension 226 is here illustrated as an isolated feature on the first major surface 204. However, there may be other structures arranged on the first major surface 204. For example, the released extension 226 may be at least partially embedded in a material.

Referring now to FIG. 3, a foldable layered connection is schematically illustrated in a perspective view. The illustration has been purposely simplified in order to more clearly convey the features discussed below. A released extension 326 is shown on a substrate 302. In this example, a portion of the substrate 302 has been removed, thereby forming a hole 340 in the substrate 302. The released extension 326 here folds over a free edge 338 towards the second major surface 306 of the substrate 302. The size of the hole 340 is preferably large enough to allow the released extension 326 to pass through towards the second major surface 306. The flexibility of the released extension 326 may facilitate the folding through the hole 340 such that the hole 340 need not necessarily be as long as a length of the released extension 326.

Referring now to FIG. 4, a foldable layered connection is schematically illustrated in a perspective view. The illustration has been purposely simplified in order to more clearly convey the features discussed below. A released extension 426 is shown on a substrate 402. In this example, the released extension 426 comprises a first and a second sub-extension 442, 444. Each sub-extension 442, 444 may be similar in composition to the released extensions discussed in the sections above, e.g. the sub-extensions 442, 444 may comprise a layer of connector material, i.e. a core of connector material, at least partly encapsulated by flexible material. The first and second sub-extension 442, 444 may be configured to be folded, e.g. moved, independently from each other. It may be noted that in the illustrated example a gap is present between the first and second sub-extension 442, 444 along the y-axis. However, the size of the gap may vary within the scope of the inventive concept. The first and second sub-extension 442, 444 here fold towards the second major surface 406 of the substrate 402.

It should be noted that although the first and second sub-extension 442, 444 are illustrated having the same widths along the y-axis, the width and/or length of the sub-extensions may be different compared to each other.

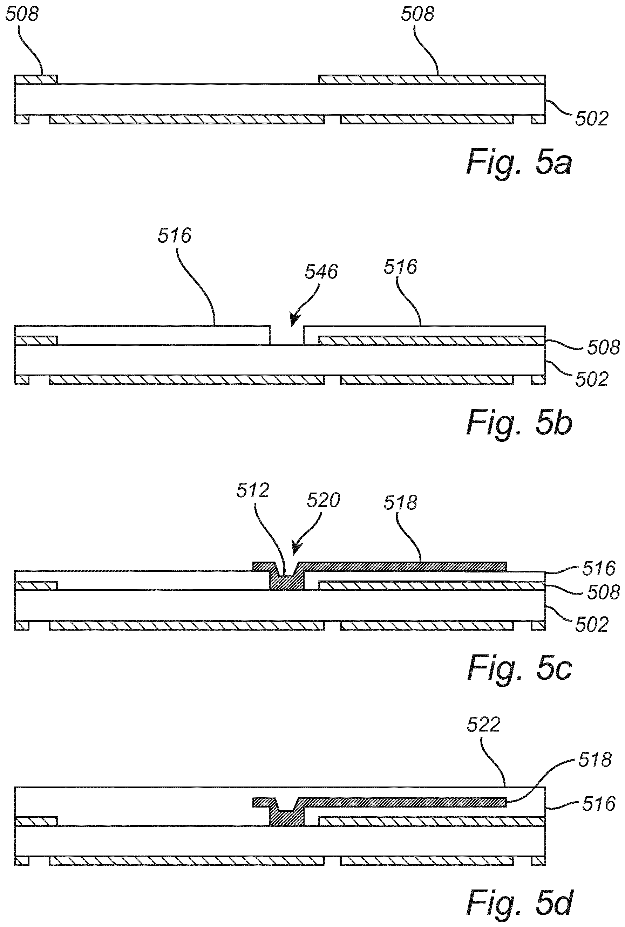

Referring now to FIGS. 5a - 5h, a method for manufacturing a foldable layered connection according to one aspect of the inventive concept is illustrated. It is to be understood that any of the steps or features disclosed in conjunction with the previous figures may be incorporated into the following aspect. Further, some steps are similar to what is disclosed in conjunction with FIGS. 1a - 1k, and will for the sake of brevity not be repeated in the following paragraphs. It may be noted the second layer of connector material as referred to in the following paragraphs correspond in part to the first layer of connector material as disclosed in conjunction with FIGS. 1a - 1k.

Referring first to FIG. 5a, a substrate 502 is provided, and a first layer of sacrificial material 508 is provided over the substrate 502. A pattern, shape or form of an extension referred to below may be determined by the pattern, shape or form of the first layer of sacrificial material 516.The substrate 502 and the first layer of sacrificial material 508 may be provided in one step, e.g. the substrate 502 and the first layer of sacrificial material 508 may be provided as a pre-fabricated piece in the method according to the inventive concept. It is further envisioned that additional steps of the method according to the inventive concept may be performed in a single step, e.g. may be provided as a pre-fabricated piece. On the contrary, it is also envisioned that the substrate 502 may first be provided, and that the first layer of sacrificial material 508 may subsequently be provided over the substrate 502, as illustrated.

Referring now to FIG. 5b, a first layer of flexible material 516 is provided over the substrate 502 and the first layer of sacrificial material 508, thereby at least partially encapsulating the first layer of sacrificial material 508.

Further, an opening 546 has been provided in the first layer of flexible material 516, thereby exposing at least a portion of the substrate 502. As is readily understood by the person skilled in the art, the opening 546 may be provided by e.g. removing part of the first layer of flexible material 516, and/or via masking when providing the first layer of flexible material 516.

Referring now to FIG. 5c, a first layer of connector material 518 has been provided onto the first layer of flexible material 516 and the substrate 502. The first layer of connector material 518 is in contact with the substrate 502, thereby forming a first contact 512 of connector material and a node of connector material 520. The first layer of connector material 518 may be patterned to conform to a patterning of the first layer of sacrificial material 508. In other words, the first layer of connector material 518 may have a similar shape as the first layer of sacrificial material 508.

Referring now to FIG. 5d, a second layer of flexible material 522 has been provided over the first layer of connector material 518. In particular, the second layer of flexible material 522 is provided onto the first layer of connector material 518. The second layer of flexible material 522 is in contact with the first layer of flexible material 516, thereby at least partially encapsulating the first layer of connector material 518.

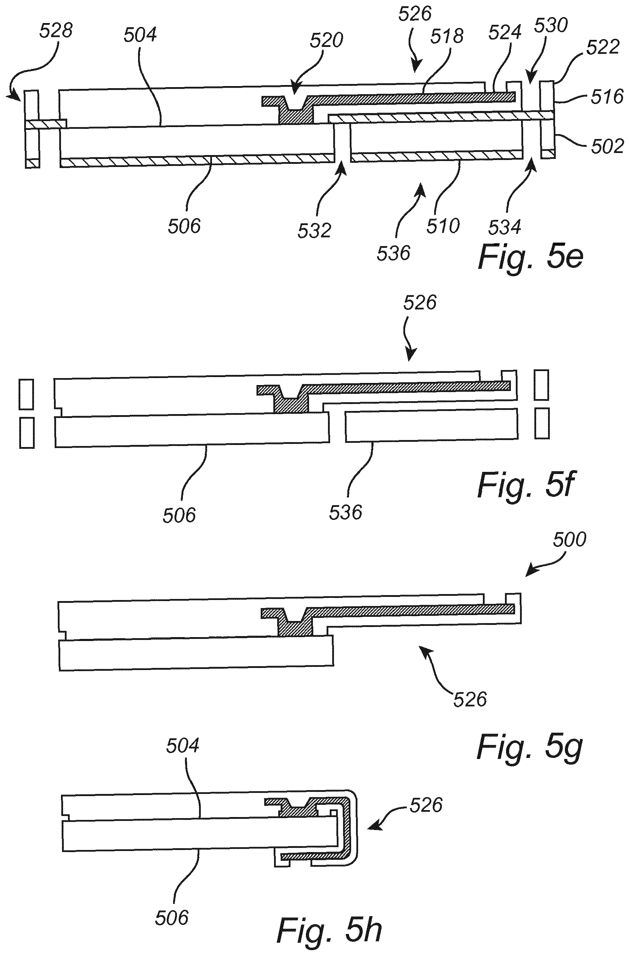

Referring now to FIG. 5e, at least a portion of the first layer of connector material 518 has been exposed, thereby forming a second contact of connector material 524. The second contact of connector material 524 may be in contact with the first contact of connector material 512 via the first layer of connector material 518. The second contact of connector material 524 may enable input to and/or output of a signal from the foldable layered connection.

Further, a portion of the first and second layer of flexible material 516, 522 has been removed in order to at least partially expose an extension 526 comprising at least part of the first and second layer of flexible material 516, 522, and the at least partly encapsulated first layer of connector material 518. In other words, the extension 526 may comprise a core of connector material, and flexible material arranged to at least partially enclose the core. Thus, the at least partly encapsulated first layer of connector material 518 may be seen as a core. By removing a portion of the first and second layer of flexible material 516, 522, the extension 526 may be laid bare from neighboring foldable layered connections 528 manufactured on the same substrate 502. The removal of a portion of the first and second layer of flexible material 516, 522 may also provide for that the extension 526 will be released, as described in conjunction with FIG. 5f, when the first layer of sacrificial material 508 is removed. It should be noted that the illustrated example only shows a two dimensional representation of the inventive concept, i.e. in a xz-plane. In particular, a portion of flexible material may be removed also in a plane not shown in the illustrated example, e.g. in a xy-plane. Further, the removal of a portion of the first and second layer of flexible material 516, 522 may also form an access channel 530 arranged to access sacrificial material, e.g. the first layer of sacrificial material 508.

Still referring to FIG. 5e, a first and a second channel 532, 534 has been formed. The first and second channels may 532, 534 may be formed by e.g. etching. The first and second channels 532, 534 may extend through the substrate 502 and reach the first layer of sacrificial material 508. A second layer of sacrificial material 510 may facilitate the forming of the channels 532, 534. Further, the first and second channel 532, 534 may define an isolated portion 536 comprising part of the substrate 502 and part of the second layer of sacrificial material 510. The isolated portion 536 may be connected to the extension 526 via the first layer of sacrificial material 508. The isolated portion 536 may be removed by removing the second layer of sacrificial material 510.

As is readily understood by the person skilled in the art, the first and second channels 532, 534 may be arranged on the first major surface of the substrate 504, the second major surface of the substrate 506, or both on the first and second major surfaces 504, 506 of the substrate.

Referring now to FIG. 5f, the first layer of sacrificial material has been removed, thus freeing and removing the isolated portion 536 from the rest of the foldable layered connection. Further, the extension 526 is released, and allowed to fold towards the second major surface 506. Also the second layer of sacrificial material has been removed.

Referring now to FIG. 5g, the released extension 526 of the foldable layered connection 500 is illustrated.

Referring now to FIG. 5h, the released extension 526 has folded towards the second major surface 506, and the released extension 526 has contacted the second major surface 506, thereby providing routing between the first major surface 504 and the second major surface 506. It may be noted that in the illustrated example, the second contact of connector material is facing away from the second major surface 506. However, it is also envisioned that the second contact of connector material may be facing towards the second major surface 506 in a folded state, such that a connection between the first major surface 504 and the second major surface 506 is achieved

The inventive concept has mainly been described above with reference to a few embodiments. However, as is readily appreciated by a person skilled in the art, other embodiments than the ones disclosed above are equally possible within the scope of the inventive concept, as defined by the appended patent claims.

### List of reference signs

- 100: Foldable layered connection
- 102: Substrate
- 104: First major surface
- 106: Second major surface
- 108: First layer of sacrificial material
- 110: Second layer of sacrificial material
- 112: First contact of connector material
- 114: Other arrangements or structures
- 116: First layer of flexible material
- 118: Second layer of connector material
- 120: Node of connector material
- 122: Second layer of flexible material
- 124: Second contact of connector material
- 126: Extension
- 128: Neighboring foldable layered connection
- 130: Access channel
- 132: First channel
- 134: Second channel
- 136: Isolated portion
- 138: Free edge
- 202: Substrate
- 204: First major surface
- 206: Second major surface
- 226: Extension
- 238: Free edge
- 302: Substrate
- 306: Second major surface
- 326: Extension
- 338: Free edge
- 340: Hole
- 402: Substrate
- 406: Second major surface
- 426: Extension
- 442: First sub-extension
- 444: Second sub-extension
- 500: Foldable layered connection
- 502: Substrate
- 504: First major surface
- 506: Second major surface
- 508: First layer of sacrificial material
- 510: Second layer of sacrificial material
- 512: First contact of connector material
- 516: First layer of flexible material
- 518: First layer of connector material
- 520: Node of connector material
- 522: Second layer of flexible material
- 524: Second contact of connector material
- 526: Extension
- 528: Neighboring foldable layered connection
- 530: Access channel
- 532: First channel
- 534: Second channel
- 536: Isolated portion
- 546: Opening

## Claims

1. A method for manufacturing a foldable layered connection (500) on a substrate (502), the method comprising:
providing a substrate (502) having a first major surface (504) and an opposing second major surface (506);
providing a first layer of sacrificial material (508) over the first major surface (504);
providing a first layer of flexible material (516) over the first layer of sacrificial material (508), thereby at least partially encapsulating the first layer of sacrificial material (508);
providing an opening in the first layer of flexible material (516), thereby exposing at least a portion of the substrate (502);
providing a first layer of connector material (518) over the first layer of flexible material (516) and the substrate (502), the first layer of connector material (518) being in contact with the substrate (502), thereby forming a first contact of connector material and a node of connector material (520);
providing a second layer of flexible material (522) over the first layer of connector material (5118), the second layer of flexible material (522) being in contact with the first layer of flexible material (516), thereby at least partly encapsulating the first layer of connector material (518);
exposing at least a portion of the second layer of connector material (518), thereby forming a second contact of connector material (524); and
removing the first layer of sacrificial material (508) and a portion of the substrate (102), thereby forming a released extension (526) which is foldable towards the second major surface of the substrate (506), the released extension (526) comprising at least part of the first and second layer of flexible material (516, 522), and the at least partly encapsulated first layer of connector material (518).

2. The method according to claim 1, wherein the step of providing the opening in the first layer of sacrificial material is performed by etching.

3. The method according to claim 1 or 2, further comprising:
forming at least one access channel (530) arranged to access the first layer of sacrificial material (508),
wherein the step of providing the opening in the first layer of sacrificial material (508) is performed by etching via the at least one access channel (530).

4. The method according to claim 2 or 3, wherein the etchant is HF.

5. The method according to any one of the preceding claims, wherein the released extension (526) is straight or meander shaped.

6. The method according to any one of the preceding claims, wherein the sacrificial material is SiO₂.

7. The method according to any one of the preceding claims, wherein the flexible material is polyimide.

8. The method according to any one of the preceding claims, wherein the first and second layer of flexible material (516, 522) has the same thickness.

9. The method according to any one of the preceding claims, wherein the substrate (502) is a silicon wafer or a printed circuit board.

10. The method according to any one of the preceding claims, wherein the connector material is an electrically conductive material.

11. The method according to any one of the preceding claims, wherein the released extension (526) is brought into contact with the second major surface (506), thereby achieving a contact between the first major surface (504) and the second major surface (506).

12. A foldable layered connection (100, 500) comprising:
a substrate (102, 502) having a first major surface (104, 504) and an opposing second major surface (106, 506);
a node of connector material (120, 520) arranged to contact the substrate (102, 502) via the first major surface (104, 504);
a released extension (126, 526) comprising a core of connector material arranged to be in communicative contact with the node of connector material (120, 520), and flexible material arranged to at least partially enclose the core;
wherein the released extension (126, 526) is configured to be hingedly connected to the node (120, 520) and to fold towards the second major surface (106, 506).

13. The foldable layered connection according to claim 12, wherein the released extension (126, 526) is further configured to fold towards the second major surface (106, 506) such that the released extension (126, 526) is brought into contact with the second major surface (106, 506), thereby providing routing between the first major surface (104, 504) and the second major surface (106, 506).

14. Use of a foldable layered connection (100, 500) according to claim 12 or 13 on a silicon wafer or a printed circuit board.
